# EUROPÄISCHE PATENTSCHRIFT

(11) **EP 0 822 602 B1**
(45) Veröffentlichungstag und Bekanntmachung des Hinweises auf die Patenterteilung: **06.02.2002**
(21) Anmeldenummer: 97112532.3
(22) Anmeldetag: 22.07.1997
(51) Int. Cl.: H01L 41/18, H01L 41/20

(54) **Vorrichtung zur Verformung einer Trägerstruktur mittels elektrischer oder magnetischer Effekte**
Device for the deformation of a support by electric or magnetic effects
Dispositif pour la déformation d'un support par un effet électrique ou magnétique

(30) Priorität: 01.08.1996 DE 19631026
(43) Veröffentlichungstag der Anmeldung: 04.02.1998
(73) Patentinhaber: EUROCOPTER DEUTSCHLAND GmbH, D-81663 München (DE)
(72) Erfinder: Bansemir, Horst, Dr., 81825 München (DE)
(74) Vertreter: Asch, Konrad, Dipl.-Ing.

(56) Entgegenhaltungen:
- EP-A- 0 468 796
- EP-A- 0 674 350
- WO-A-94/27331
- DE-A- 4 025 618
- GB-A- 2 128 849
- US-A- 4 933 230
- US-A- 5 072 035
- RODGERS J P ET AL: "Characterization of interdigitated electrode piezoelectric fiber composites under high electrical and mechanical loading for rotorcraft application" SMART STRUCTURES AND MATERIALS 1996. SMART STRUCTURES AND INTEGRATED SYSTEMS, SAN DIEGO, CA, USA, 26-29 FEB. 1996, Bd. 2717, ISSN 0277-786X, PROCEEDINGS OF THE SPIE - THE INTERNATIONAL SOCIETY FOR OPTICAL ENGINEERING, 1996, SPIE-INT. SOC. OPT. ENG, USA, Seiten 642-659, XP002045736

## Beschreibung

Die vorliegende Erfindung betrifft eine Vorrichtung zur Verformung einer Trägerstruktur mittels elektrischer oder magnetischer Effekte, die aus einem in einem Bettungsmaterial angeordneten Faserverbund besteht sowie aus piezoelektrischen Keramiken oder Polymeren, elektrostriktiven Keramiken oder magnetostriktiven Materialien wie beispielsweise die Legierung TERFENOL-D, die mit der Trägerstruktur verbunden sind.

Im folgenden soll stellvertretend für die obigen Materialien die Erfindung anhand von Piezokeramiken beschrieben werden.

Es ist bekannt, daß Piezokeramiken besondere Eigenschaften aufweisen. Wird ein derartiges Material mechanisch deformiert, so entsteht auf seinen Oberflächen eine elektrische Spannung, die proportional zur Deformation ist. Diese Eigenschaft wird beispielsweise in Feuerzeugen zur Funkenerzeugung ausgenutzt. Umgekehrt deformiert sich ein piezoelektrisches Material, z. B. eine Piezokeramik, beim Anlegen einer elektrischen Spannung. Dieser Effekt wird für Aktuatoren und Stellelemente in der Mikromechanik, z. B. beim Tunnelmikroskop, verwendet.

Dieser piezoelektrische Effekt führt bei Piezokeramiken bei mittleren Kräften zu kleinen Verformungen. Diese sind bis zu hohen Frequenzen nutzbar, wobei jedoch aufgrund der geringen Verformungen für bestimmte Anwendungszwecke aufwendige Übersetzungsmechnismen vorgesehen werden müssen.

In analoger Weise können Verformungen durch die Verwendung magnetostriktiver Materialien mittels magnetischer Effekte erzielt werden.

In der US 4,933,230 A wird ein Polymer-Matrix-Werkstoff in Verbindung mit dem Gebrauch von piezokeramischen Materialien vorgeschlagen. Das Dokument beschreibt die Zusammensetzung des Werkstoffes zur Aufnahme von piezokeramischen Fasern.

Die EP 0674350 A1 beschreibt einen Ultraschall-Aktuator. Das Dokument benennt die Möglichkeit zum Kleben eines Piezoelements auf einer Trägerstruktur (dortige Seite 5, 43. Zeile) vermittelt jedoch keine Hinweise auf Art und Weise der Klebebefestigung.

Die EP 0468796 A1 beschreibt einen piezoelektrischen Aktuator zum Beispiel für eine Düse des Druckkopfes eines Tintendruckers. Das Dokument betrifft die Fertigung von piezoelektrischen Strukturen auf einem dünnwandigen Keramiksubstrat.

Die WO 94/27331 A1 beschreibt einen Piezoaktuator, der als Biege-Aktuator funktioniert. Das Dokument beschreibt, daß Schichten von Piezokeramik als Streifen mittels Klebstoffschicht auf einer Trägerstruktur verklebbar sind. Es gibt keine Hinweise hinsichtlich einer Vorzugsrichtung zum Verkleben der Streifen auf der Trägerstruktur.

Mit der DE 4025618 A1 ist eine Vorrichtung nach dem Oberbegriff des Patentanspruchs 1 bekannt. Diese Vorrichtung umfaßt ein piezoelektrisches Röhrchen, welches einen rohrförmigen Polygonkörper mit in Längsrichtung der Polygonseiten angeordneten Piezoplatten aufweist. Auf dem Polygonendorn ist eine Faser im spitzen Winkel zur Längsrichtung aufgewickelt und mit einem als Matrix dienenden Kleber umgeben. Dieser Faserverbund kann mehrlagig aufgebaut sein. Nach der dortigen Figur 4 sind auf der Außenseite des Polygonkörpers langgestreckte Piezoplatten angebracht. Durch Anlegen einer Spannung an die langgestreckten Piezoplatten ist eine axiale Ausdehnung des Röhrchens erzielbar.

Im Hubschrauberbau z.B. besteht unter Einsatz von Faserverbundwerkstoffen seit langem der Wunsch, die Rotorblätter elektrisch anzusteuern, um so auf die mechanischen Teile, wie Steuerstanden und Taumelscheibe, als Stellglieder für die Verstellung des Anstellwinkels der Rotorblätter verzichten zu können. Auch eine höher- harmonische Steuerung zur Last-, Kärm- und Schwingungsverminderung ist wünschenswert; bisher sind jedoch derartige elektrisch ansteuerbare Vorrichtungen wegen der geringen Verformung und Belastbarkeit der piezoelektrischen Keramiken nur stark eingeschränkt nutzbar.

Aufgabe der vorliegenden Erfindung ist es, eine Vorrichtung zur Verformung einer Trägerstruktur so auszubilden, daß insbesondere in einer vorgegebenen Richtung eine besonders intensive Verformung der Trägerstruktur unter direkter elektrischer Ansteuerung der Piezokeramiken bei mittleren Kräften erreicht wird.

Ausgehend von einer Vorrichtung der eingangs näher genannten Art erfolgt die Lösung dieser Aufgabe mit den im kennzeichnenden Teil des Anspruchs 1 angegebenen Merkmalen; vorteilhafte Ausgestaltungen sind in den Unteransprüchen beschrieben.

Mit der erfindungsgemäßen Vorrichtung bestehend aus einer Trägerstruktur, mit z. B. rechteckigem Querschnitt, die auf zwei sich gegenüberliegenden Seiten oder auch auf einer Seite z. B. Piezokeramiken aufweist, wird eine aktive erhebliche Verformung der Trägerstruktur ermöglicht und zwar unter direkter elektrischer Ansteuerung der Piezokeramiken. Dabei wird die elektrisch erzeugte Verformung der Piezokeramiken in Längsrichtung (x-Richtung) auf die Trägerstruktur übertragen, die dadurch in Querrichtung (y-Richtung) erheblich verformt wird. Statt piezoelektrische Keramiken können auch Polymere, elektrostriktive oder magnetostriktive Materialien, wie z. B. die unter der Bezeichnung TERFENOL-D bekannte Legierung, verwendet werden.

Im folgenden wird die Erfindung anhand der Zeichnung näher erläutert, in der ein vorteilhaftes Ausführungsbeispiel im Zusammenhang mit Piezokeramiken dargestellt ist. Es zeigen
Figur 1 eine Draufsicht auf und einen Querschnitt durch eine Trägerstruktur ohne Piezokeramiken sowie die Anordnung der einzelnen Fasern und
Figur 2 eine Draufsicht auf und einen Querschnitt durch die mit den Piezokeramiken versehene Trägerstruktur.

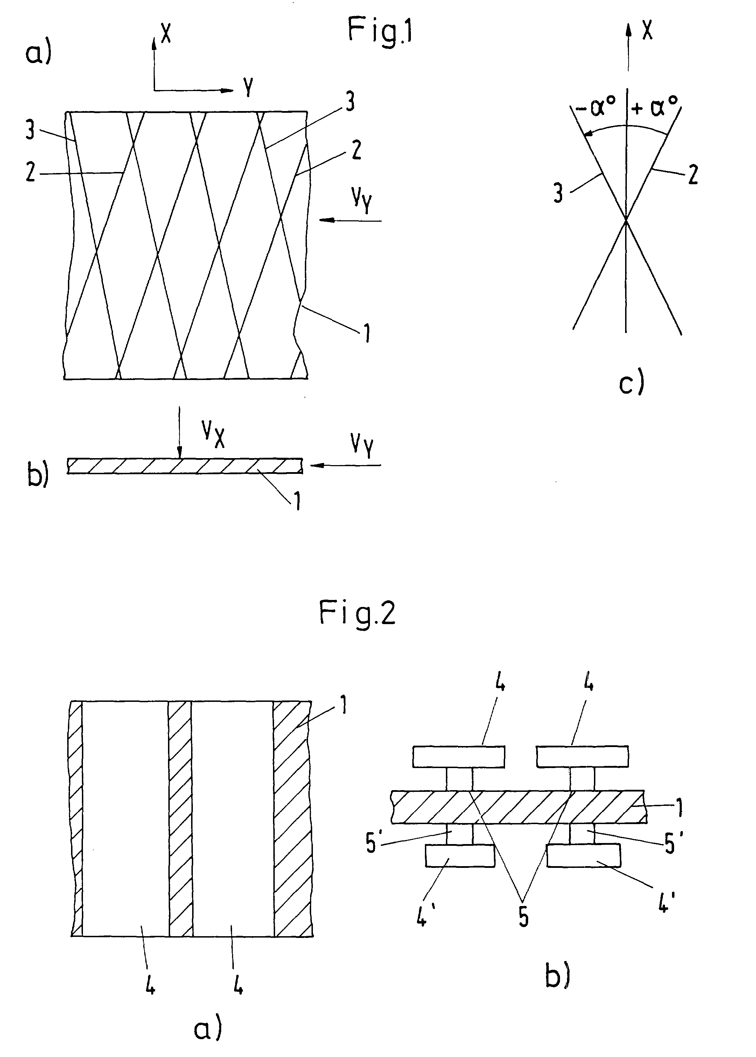

Figur 1a zeigt eine Draufsicht auf einen Ausschnitt einer Trägerstruktur 1, welche gemäß Figur 1b einen rechteckigen Querschnitt aufweist. Die Trägerstruktur 1 besteht dabei aus einem Faserverbund, vorzugsweise einem hochmoduligem Faserverbund (d. h. mit einem hohen Elastizitätsmodul), wobei der Faserverbund in ein Bettungsmaterial, z. B. ein geeignetes Harz, eingebettet ist und eine Vielzahl von Fasern aufweist, die mit 2,3 bezeichnet sind und deren Richtung ein Winkel ± α zur mit X bezeichneten Längsrichtung einschließen (Figur 1c), während mit Y die Querrichtung entsprechend der Längsachse der Trägerstruktur 1 bezeichnet ist.

Der Winkel ±α für den Verlauf der Fasern des hochmoduligen Faserverbundes beträgt vorzugsweise ± 20° bis ± 45°, wobei die Querkontraktionszahl der in Figur 1 dargestellten Trägerstruktur in der Größenordnung von 2,0 liegt und diese eine Vergrößerung der durch die Piezokeramiken verursachten Ausdehnung in Längsrichtung X bewirkt.

Eine oder auch zwei, in diesem Fall sich gegenüberliegende Seiten und zwar die großen Seiten der Trägerstruktur 1, sind nun mit einer Vielzahl von streifenförmigen Piezokeramiken 4, 4' belegt, welche für die gewünschte Verformung der Trägerstruktur sorgen, sofern sie mit einer elektrischen Spannung beaufschlagt werden.

Figur 2 läßt ferner erkennen, daß die Piezokeramiken auf einer oder auf den beiden großen Seiten der Trägerstruktur aus einer Vielzahl einzelner Streifen 4, 4' bestehen, welche nicht über ihre gesamte Breite, sondern nur über einen Teil ihrer Breite, d. h. in den Bereichen 5, 5' (Figur 2b), jedoch über ihre gesamte Längsausdehnung mit den entsprechenden Seiten der Trägerstruktur verklebt sind. Die Piezokeramik 4 ( gegebenenfalls auch 4') verlaufen dabei in Längsrichtung X und senkrecht zur Querrichtung Y.

Durch die nur teilweise Verklebung der Keramikstreifen 4, 4' mit der Trägerstruktur 1 wird erreicht, daß die Steifigkeit und die aktive Dehnung der Piezokeramiken in der Längsrichtung X voll wirksam ist, in der Querrichtung Y jedoch nur zum Teil. Auf diese Art erhält man ein orthotropes Verhalten des in dieser Ebene eigentlich isotropen Werkstoffes. Durch Variation des Verhältnisses der Klebebreite zur Streifenbreite kann die Stärke dieser Orthotropie eingestellt werden.

Die Trägerstruktur kann sowohl ein Rotorblatt für einen Hubschrauber als auch ein Aktuator sein; wird die Trägerstruktur als Aktuator ausgebildet, so bewirkt eine mechanische Verlängerung in Querrichtung Y keine oder nur eine äußerst geringe Verformung in Längsrichtung X und damit keine oder fast keine Beanspruchung der Piezokeramiken.

Dadurch entfällt die Notwendigkeit, daß die Piezokeramiken unter Vorspannung auf der Trägerstruktur angeordnet werden; eine elektrisch über die Piezokeramiken erzeugte Verformung in Längsrichtung X führt hingegen zu einer erheblichen Verlängerung und damit Verformung des Aktuators in Richtung dessen Längsachse entsprechend der Y Richtung.

Wird die Trägerstruktur nur einseitig mit Piezokeramiken in Streifenform gelegt, so erhält man damit Biegestrukturen, die z. B. als Klappen verwendbar sind.

## Patentansprüche

1. Vorrichtung zur Verformung einer Trägerstruktur (1) mittels elektrischer oder magnetischer Effekte, die aus einem in einem Bettungsmaterial angeordneten Faserverbund besteht, wobei der Faserverbund aus einer Vielzahl von Fasern (2,3) besteht, sowie aus piezoelektrischen Keramiken oder Polymeren, elektrostriktiven Keramiken oder magnetostriktiven Materialien, die mit dem Faserverbung verbunden sind und als Streifen auf der Trägerstruktur (1) angeordnet sind, **dadurch gekennzeichnet, daß** die Fasern (2,3) unter einem spitzen Winkel von ± 20° bis ± 45° zur Längsrichtung (X) der Trägerstruktur (1) verlaufen und daß die Streifen (4) von piezoelektrischen Keramiken oder Polymeren, elektrostriktiven Keramiken oder magnetostriktiven Materialien in Längsrichtung (X) auf der Trägerstruktur (1) angeordnet sind, wobei die Streifen (4) nur über einen Teil ihrer Breite (5), aber über die Streifenlänge mit der Trägerstruktur verklebt sind.

2. Vorrichtung nach Anspruch 1, **dadurch gekennzeichnet, daß** die Trägerstruktur (1) einen rechteckigen Querschnitt aufweist.

3. Vorrichtung nach Anspruch 2, **dadurch gekennzeichnet, daß** die piezoelektrischen Keramiken oder Polymeren, elektrostriktiven Keramiken oder magnetostriktiven Materialien (4) auf nur einer der großen Längsseiten der Rechteckkontur der Trägerstruktur (1) aufgebracht sind.

4. Vorrichtung nach Anspruch 2, **dadurch gekennzeichnet, daß** die piezoelektrischen Keramiken oder Polymeren, elektrostriktiven Keramiken oder magnetostriktiven Materialien auf den beiden großen Längsseiten der Rechteckkontur der Trägerstruktur (1) aufgebracht sind.

5. Vorrichtung nach einem der vorstehenden Ansprüche 1 bis 2, **dadurch gekennzeichnet, daß** die Trägerstruktur (1) einen ovalen oder kreisförmigen Querschnitt aufweist.

6. Vorrichtung nach einem der vorstehenden Ansprüche, **dadurch gekennzeichnet, daß** die Trägerstruktur (1) ein Rotorblatt für einen Hubschrauber ist.

7. Vorrichtung nach einem der vorstehenden Ansprüche, **dadurch gekennzeichnet, daß** die Trägerstruktur (1) ein Aktuator ist.

## Claims

1. Device for deforming a carrier structure (1) by means of electric or magnetic effects, comprising a fibre composite arranged in a matrix, wherein the fibre composite comprises a plurality of fibres (2, 3), and piezoelectric ceramics or polymers, electro-strictive ceramics or magneto-strictive materials which are joined to the fibre composite and are arranged as strips on the carrier structure (1), **characterised in that** the fibres (2, 3) extend at an acute angle of ±20° to ±45° to the longitudinal direction (X) of the carrier structure (1), and **in that** the strips (4) of piezo-electric ceramics or polymers, electro-strictive ceramics or magneto-strictive materials are arranged in the longitudinal direction (X) on the carrier structure (21), the strips (4) being cemented to the carrier structure only over part of their width (5), but over the length of the strip.

2. Device according to claim 1, **characterised in that** the carrier structure (1) has a rectangular cross-section.

3. Device according to claim 2, **characterised in that** the piezo-electric ceramics or polymers, electro-strictive ceramics or magneto-strictive materials (4) are applied to only one of the large longitudinal sides of the rectangular contour of the carrier structure (1).

4. Device according to claim 2, **characterised in that** the piezo-electric ceramics or polymers, electro-strictive ceramics or magneto-strictive materials are applied to both large longitudinal sides of the rectangular contour of the carrier structure (1).

5. Device according to one of the preceding claims 1 to 2, **characterised in that** the carrier structure (1) has an oval or circular cross-section.

6. Device according to one of the preceding claims, **characterised in that** the carrier structure (1) is a rotor blade for a helicopter.

7. Device according to one of the preceding claims, **characterised in that** the carrier structure (1) is an actuator.

## Revendications

1. Dispositif pour déformer une structure porteuse (1) par effet magnéticoélectrique, cette structure comprenant un composé de fibres intégrées dans de la matière, le composé de fibres étant formé d'un grand nombre de fibres (2, 3) ainsi que de céramique ou de polymère piézo-électriques, de céramiques électrostrictives ou de matières magnétosrictives, reliées au composé de fibres en étant intégrées sous forme de rubans dans la structure porteuse (1),
**caractérisé en ce que**
les fibres (2, 3) font un angle aigu de ± 20° à ± 45° par rapport à la direction longitudinales X de la structure de support (1) et
des bandes (4) de céramiques ou de polymères piézo-électriques ou de céramiques électrostrictives ou de matières magnétostrictives sont disposées dans la direction longitudinale X sur la structure porteuse (1),
les bandes (4) n'étant collées que sur une partie de la largeur (5) mais sur toute la longueur de la bande à la structure porteuse.

2. Dispositif selon la revendication 1,
**caractérisé en ce que**
la structure porteuse (1) est de section rectangulaire.

3. Dispositif selon la revendication 2,
**caractérisé en ce que**
les céramiques ou les polymères piézo-électriques, les céramiques électrostrictives ou les matières magnétostrictives (4) sont appliquées seulement sur l'un des grands côtés longitudinaux du contour rectangulaire de la structure porteuse (1).

4. Dispositif selon la revendication 1,
**caractérisé en ce que**
les céramiques ou les polymères piézo-électriques, les céramiques électrostrictives ou les matières magnétostrictives (4) sont appliquées sur les deux grands côtés longitudinaux du contour rectangulaire de la structure porteuse (1).

5. Dispositif selon l'une quelconque des revendications 1 et 2,
**caractérisé en ce que**
la structure porteuse (1) a une section ovale ou circulaire.

6. Dispositif selon l'une quelconque des revendications précédentes,
**caractérisé en ce que**
la structure porteuse (1) est une lame de rotor d'hélicoptère.

7. Dispositif selon l'une quelconque des revendications précédentes,
**caractérisé en ce que**
la structure porteuse (1) est un actionneur.
